Europäisches Patentamt

European Patent Office

Office européen des brevets

(19)

(11)  **EP 1 377 844 B1**

(12)  **EUROPÄISCHE PATENTSCHRIFT**

(45) Veröffentlichungstag und Bekanntmachung des Hinweises auf die Patenterteilung:
**12.10.2005   Patentblatt 2005/41**

(21) Anmeldenummer: **02719928.0**

(22) Anmeldetag: **26.02.2002**

(51) Int Cl.⁷: **G01R 31/36**, H01M 10/42, H02J 7/00, H02J 7/14, B60R 16/02, H02P 9/08, H02J 7/02

(86) Internationale Anmeldenummer:
**PCT/EP2002/002032**

(87) Internationale Veröffentlichungsnummer:
**WO 2002/071087 (12.09.2002 Gazette 2002/37)**

(54) **VERFAHREN UND ANORDNUNG ZUR BESTIMMUNG DER PUFFERWIRKUNG EINER BATTERIE**

METHOD AND SYSTEM FOR DETERMINING THE BUFFER ACTION OF A BATTERY

PROCEDE ET DISPOSITIF POUR DETERMINER L'EFFET TAMPON D'UNE BATTERIE

(84) Benannte Vertragsstaaten:
**DE FR GB IT**

(30) Priorität: **08.03.2001   DE 10111408**

(43) Veröffentlichungstag der Anmeldung:
**07.01.2004   Patentblatt 2004/02**

(73) Patentinhaber: **DaimlerChrysler AG**
**70567 Stuttgart (DE)**

(72) Erfinder:
• **BLESSING, Alf**
  **73092 Heiningen (DE)**
• **BRINKMEYER, Horst**
  **71336 Waiblingen (DE)**
• **FRIED, Udo**
  **71336 Waiblingen-Neustadt (DE)**
• **MÄCKEL, Rainer**
  **53639 Königswinter (DE)**
• **MILLER, Wilfried**
  **70327 Stuttgart (DE)**
• **STEGE, Manfred**
  **63225 Langen (DE)**

(56) Entgegenhaltungen:
EP-A- 0 736 951          EP-A- 1 037 063
EP-A- 1 081 499          DE-A- 19 610 927
US-A- 5 761 072

## Beschreibung

Die Erfindung betrifft Verfahren zur Bestimmung der Pufferwirkung einer Batterie zur Bereitstellung einer Spannung, insbesondere für ein Fahrzeug. Desweiteren betrifft die Erfindung eine Anordnung zur Bestimmung der Pufferwirkung.

In Fahrzeugen werden zunehmend sicherheitsrelevante Funktionen elektrisch betrieben, wie z.B. elektrische Bremsen. Um sicherzustellen, daß die Funktionsfähigkeit derartiger sicherheitsrelevanter Komponenten gewährleistet ist, müssen diese permanent mit elektrischer Energie versorgt werden. Hierzu ist es bekannt, im Fahrzeug zwei Energiequellen, nämlich eine Batterie und einen Generator, vorzusehen.

Da die Lebensdauer einer konventionellen Blei-Säure-Batterie im Regelfall geringer ist als die Lebensdauer eines Fahrzeugs, kann es vorkommen, daß nur noch eine der beiden Energiequellen funktionstüchtig ist. Für diesen Fall, daß eine Batterie leer oder defekt und somit funktionsuntüchtig ist, kann es zu einem Schaden oder zu einer Überlastung der zweiten Energiequelle, dem Generator, kommen. Dies kann dazu führen, daß die Versorgung der Verbraucher nicht mehr sichergestellt ist. Darüber hinaus kann das Fahrzeug in einen sicherheitskritischen Zustand gelangen. Aus diesem Grunde sind Maßnahmen erforderlich, die auf der einen Seite den Fahrer warnen, auf der anderen Seite aber auch das Bordnetz und damit das Fahrzeug möglichst lange in einem betriebssicheren Zustand halten. Insbesondere muß sichergestellt sein, daß betriebs- und vor allem sicherheitsrelevante Verbraucher, wie z.B. Motorelektronik, elektrische Bremsen, nicht abgeschaltet werden. Zur Gewährleistung der Funktionsfähigkeit solcher sicherheitsrelevanter Aggregate ist neben der Sicherstellung eines minimalen Strombedarfs ein minimales Spannungsniveau einzuhalten. Dies kann üblicherweise mittels des Generators gewährleistet werden. Sollte die Batterie aber in einem tiefentladenen Zustand oder anderweitig defekt sein, so ist eine Pufferwirkung dieser nicht mehr gegeben. Ggf. kann dies dazu führen, daß der Generator während des Betriebs durch eine Laständerung entregt wird und die Bordnetzspannung plötzlich zusammenbricht, wodurch ein Betrieb der sicherheitsrelevanten Aggregate nicht mehr sichergestellt werden kann.

Aus der DE 199 44 517 A1 ist ein Verfahren zur Bestimmung der Pufferwirkung einer Batterie zur Bereitstellung einer Spannung für ein Bordnetz eines Fahrzeugs bekannt. Hierbei wird die Spannungswelligkeit erfasst und bestimmt sowie anhand einer Überwachungseinheit auf die Einhaltung eines vorgebbaren Grenzwertes überwacht.

Weiterhin ist aus der japanischen Offenlegungsschrift JP 03-249 582 A ein Verfahren, die Qualität einer Batterie zu testen, bekannt. Hierbei wird eine Konstant-Wechselstromquelle als Belastung für die zu testende Batterie verwendet und dann ermittelt, welche Spannungspegel sich dann einstellen. Entsprechend den sich ergebenden Spannungspegeln wird dann die Qualität der Batterie bewertet. Aufgrund der Verwendung der Konstant-Wechselstromquelle ist eine derartige Anordnung jedoch nicht für eine Verwendung im Fahrzeug einsetzbar. Zudem stellt die Verwendung der Konstant-Wechselstromquelle eine Einspeisung eines Extrasignals dar, die aufwendig ist.

Die EP 1 037 063 A1 offenbart die Messung der Zelleneinzelspannung, d.h. bei einer 12V-Batterie müsste die Spannungsmessung 6mal erfolgen, wobei deren maximaler und minimaler Wert bestimmt bzw. die Differenz zwischen beiden gebildet wird. Wird diese Differenz der Zelleneinzelspannungen auf den Strom bezogen, so ergibt sich eine Widerstandsgröße, die aber nicht dem Innenwiderstand der Batterie entspricht. Bei verschiedenen Arbeitspunkten ($\Delta U/I$) ergibt sich hieraus eine Kennlinie. Hierbei handelt es sich aber um die Widerstandsdifferenz zwischen Einzelzellen. Hierdurch kann eine gealterte Batterie erkannt werden. Mit einem derartigen Verfahren kann der Ausfall einzelner Zellen bestimmt werden. Nimmt man aber an, dass die Leistungsfähigkeit der Batterie durch Entladung absinkt, so wird dies gleichmäßig bei allen Zellen geschehen. Hierbei würde der Zelleneinzelwiderstand ebenfalls gleichmäßig ansteigen. Dies führt dazu, dass beim herkömmlichen Verfahren keine Veränderung der Differenzspannungen und damit auch nicht der Differenzwiderstände zu erkennen ist. Wenn man davon ausgeht, dass die Widerstände R1 und R2 in dieser Druckschrift gleich sind, so ist die Spannungsdifferenz unabhängig vom Strom, d.h. eine Stromvariation führt hier zu keinem Messergebnis.

Weiterhin ist aus dem nächstkommenden Stand der Technik gemäß der EP 1 081 499 A1 die Bestimmung des dynamischen Innenwiderstands aus einer aus der Batterieklemmenspannung abgeleiteten Größe Vr bekannt. Hierbei wird bei jeder Messung n der interne Widerstand Rn bestimmt.

Zusammenfassend offenbaren die EP 1 081 499 A1 und die EP 1 037 063 A1 Verfahren, die äquidistant, d.h. in konstantem zeitlichem Abstand, Strom und Spannung der Batterie erfassen. In einem Fall wird die Spannung noch korrigiert. Eine Auswahl von Messwerten wird nicht beschrieben.

Der Erfindung liegt daher die Aufgabe zugrunde, ein Verfahren zur Bestimmung der Pufferwirkung einer Batterie anzugeben, bei dem eine möglichst einfache und sichere Erkennung der Funktionsfähigkeit der Batterie ermöglicht ist. Darüber hinaus soll eine besonders einfache Anordnung zur Bestimmung der Pufferwirkung der Batterie angegeben werden.

Diese Aufgabe wird erfindungsgemäß durch ein Verfahren mit den Merkmalen nach Anspruch 1 bzw. eine Vorrichtung mit den Merkmalen nach Anspruch 15 gelöst. In den Unteransprüchen sind vorteilhafte Weiterbildungen der Erfindung angegeben.

Die Erfindung geht dabei von der Überlegung aus, daß bei nachlassender Pufferwirkung der Batterie es zu einer Änderung von Filtereigenschaften der Batterie für das Bordnetz kommt. Erfindungsgemäß wird dazu der dynamische Innenwiderstand der Batterie anhand des Quotienten aus Spannungsänderung und Stromänderung bestimmt. Bevorzugt wird der dynamische Innenwiderstand auf einen vorgebbaren Minimalwert überwacht wird. Anhand der Überwachung des dynamischen Innenwiderstands auf Überschreitung eines Minimalwerts ist eine Aussage über die Pufferwirkung der Batterie ermöglicht. Je kleiner der Quotient aus Spannungsänderung zur Stromänderung ist, desto besser ist die Pufferwirkung der Batterie. Bevorzugt erfolgt dabei die Bestimmung des dynamischen Innenwiderstands bei einer nennenswerten Strom- und Spannungsänderung, z.B. bei einer Änderung von größer 1V bzw. 5A.

Für eine Aussage über die Pufferwirkung der Batterie auch bei kleinen Strom- und Spannungsänderungen wird der Innenwiderstand vorzugsweise mittels eines Wichtungsfaktors gewichtet. Hierdurch ist insbesondere eine kontinuierliche Überwachung des dynamischen Innenwiderstands und somit eine kontinuierliche Erkennung der Pufferwirkung gegeben. Als Wichtungsfaktor wird beispielsweise die Leistung gemäß folgender Beziehung $P = \Delta U \times \Delta I$ verwendet. Je nach Art und Ausführung kann der Wichtungsfaktor linear oder quadratisch bei der Bestimmung des dynamischen Innenwiderstands berücksichtigt werden.

Vorteilhafterweise wird bei Überschreiten des Grenzwerts, d.h. des Minimalwerts, eine Warnmeldung ausgegeben. Somit ist es sichergestellt, daß bei einer nicht mehr für einen Not- oder Sicherheitsbetrieb bzw. für eine kurzzeitige starke Überlastung ausreichenden Pufferwirkung der Batterie eine Warnmeldung an den Fahrer, z.B. in Form einer Signalleuchte im Armaturenbrett, ausgegeben wird.

Die erfindungsgemäße Vorrichtung weist dazu unter anderem eine Überwachungseinheit zur Bestimmung des dynamischen Innenwiderstands der Batterie anhand des Quotienten aus Spannungsänderung und Stromänderung auf.

Diese und weitere Aufgaben, Merkmale und Vorteile der vorliegenden Erfindung werden aus der nachfolgenden ausführlichen Beschreibung bevorzugter Ausführungsbeispiele der Erfindung in Verbindung mit der Zeichnung offensichtlich.

Ausführungsbeispiele der Erfindung werden anhand einer Zeichnung näher erläutert. Darin zeigen:

FIG 1     schematisch eine Anordnung zur Bestimmung der Pufferwirkung einer Batterie mit einer Sensoreinheit und einer Überwachungseinheit,
FIG 2     schematisch die Sensoreinheit,
FIG 3 bis 4     Diagramme mit einer Strom-Spannungs-Kennlinie für die Batterie, und

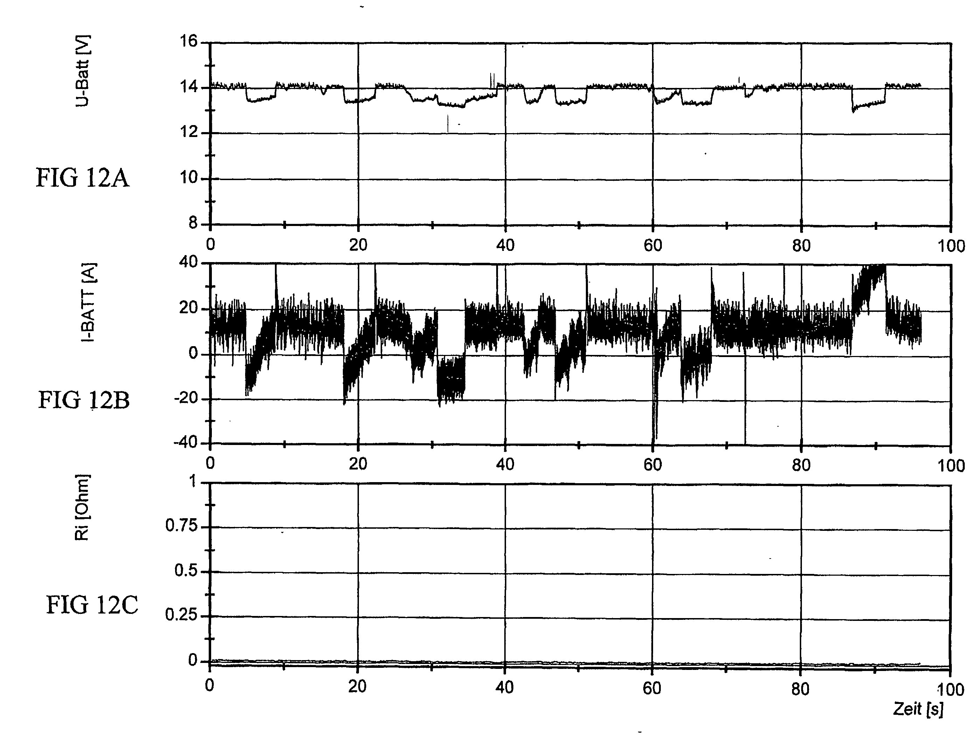

FIG 5A-5B     bis 8A-8B und 9A-9C bis 12A-12C Diagramme mit Funktionsverläufen von Spannung und Strom für verschiedene Ausführungsbeispiele.

Einander entsprechende Teile sind in allen Figuren mit den gleichen Bezugszeichen versehen.

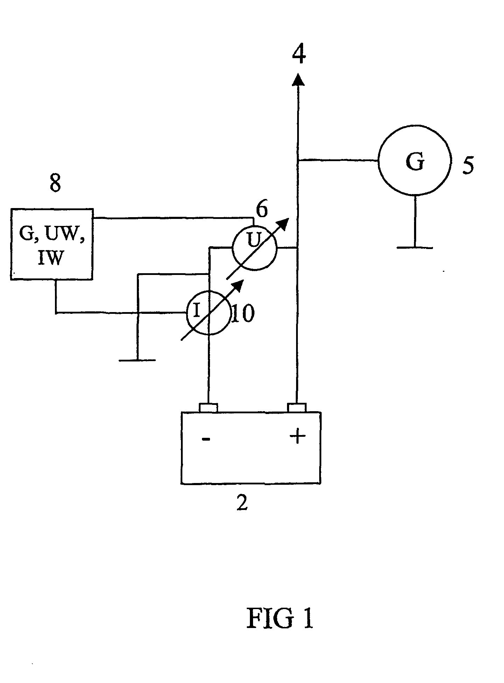

Figur 1 zeigt eine Anordnung 1 zur Bestimmung der Pufferwirkung einer Batterie 2 zur Bereitstellung einer Spannung U für ein Bordnetz 4, insbesondere eines nicht näher dargestellten Fahrzeugs. Das Bordnetz 4 wird mit Spannung U der Batterie 2 versorgt. Als zweite Energiequelle kann das Bordnetz 4 vom Generator 5 des Fahrzeugs mit Spannung U versorgt werden. Zusätzlich kann zur Kompensation von Instabilitäten im Bordnetz und bei Bedarf zum temporären Laden eine Stützbatterie bat2 (nicht gezeigt) parallel zur (Bordnetz)Batterie 2 angeordnet sein, die zugeschaltet werden kann.

Die Anordnung 1 umfaßt ein Mittel 6 zur Erfassung und Bestimmung der Spannung U und/oder der Spannungswelligkeit UW (im weiteren kurz Spannungssensor 6 genannt) sowie eine Überwachungseinheit 8 zur Überwachung der Spannung U und/oder der Spannungswelligkeit UW auf die Einhaltung eines vorgebbaren Extremwerts $G_U$, $G_{UW}$. Zusätzlich weist die Anordnung 1 ein Mittel 10 zur Erfassung und Bestimmung des Stroms I und/oder der Stromwelligkeit IW (im weiteren kurz Stromsensor 10 genannt) auf. Die Kenngrößen des Bordnetzes 4, wie die Spannung U, die Spannungswelligkeit UW, der Strom I und/oder die Stromwelligkeit IW werden zur Bestimmung der Pufferwirkung der Batterie 2 mittels der Überwachungseinheit 8 auf die Einhaltung eines vorgebbaren Extremwerts $G_U$, $G_{UW}$, $G_I$ bzw. $G_{IW}$ überwacht. Dabei wird eine Über- und/oder Unterschreitung des vorgegebenen Extremwerts $G_U$, $G_{UW}$, $G_I$ bzw. $G_{IW}$ überwacht. Mit geringer werdender Pufferwirkung der Batterie 2 nimmt die Spannungswelligkeit UW zu bzw. die Stromwelligkeit IW ab. Die Spannungswelligkeit UW wird insbesondere durch Einschaltung von Verbrauchern, z.B. vom Generator, von der Zündanlage, hervorgerufen.

Daher wird in einer beispielhaften Ausgestaltung die Spannungswelligkeit UW überwacht. Bei der Überwachung der Stromwelligkeit IW wird das gegenüber der Spannungswelligkeit reziproke Verhalten analysiert. Kommt es bei der Überwachung der Spannungswelligkeit UW und/oder der Stromwelligkeit IW zu einer Überschreitung bzw. Unterschreitung des vorgegebenen Extremwerts $G_{UW}$ bzw. $G_{IW}$, so ist dies ein Indiz dafür, daß die Pufferwirkung der Batterie 2 nicht ausreichend ist.

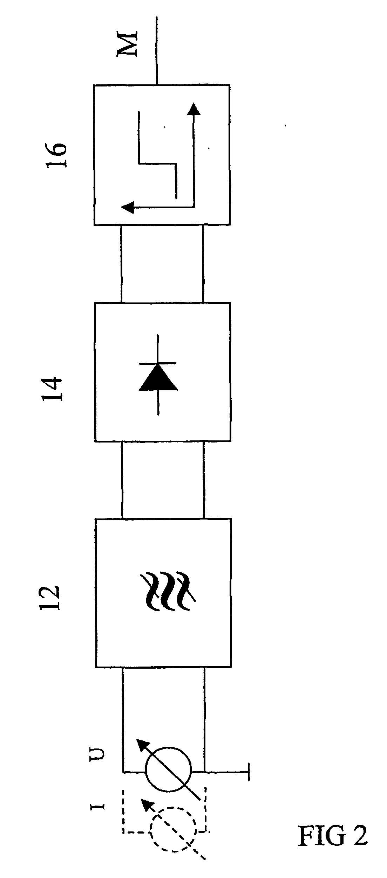

Die Überwachungseinheit 8 kann dabei schaltungstechnisch oder in Software ausgeführt sein. In Figur 2 ist beispielhaft eine schaltungstechnische Ausführung der Überwachungseinheit 8 zur Überwachung der Spannungswelligkeit UW auf die Einhaltung des zugehörigen Extremwerts $G_{UW}$ abgebildet. Dabei umfaßt die Überwachungseinheit 8 ein Filter 12, insbesondere ein Bandpass-Filter. Das Filter 12 filtert untere Frequenzanteile, insbesondere die Gleichspannung, und obere Frequenzanteile aus dem Spannungssignal U heraus. Je nach Art und Ausführung des Filters 12 ist dieses ein derartiges Filter, dessen Mittenfrequenz aus der Drehzahl des Motors oder des Generators 5 abgeleitet wird. Dem Filter 12 ist ein Gleichrichter 14 und ein Komparator 16 nachgeschaltet. Die mittels des Filters 12 aus dem Spannungssignal U herausgefilterte Schwingung wird anhand des Gleichrichters 14 in eine Gleichspannung umgewandelt und anhand des Komparators 16 mit dem vorgegebenen Extremwert $G_{UW}$ verglichen. Mit anderen Worten: Die Amplitude der Spannungswelligkeit UW wird mittels des vorgegebenen Extremwert $G_{UW}$ auf einen Maximalwert überwacht. Ist die Gleichspannung nach dem Gleichrichter 14 größer als der Maximalwert, so ist die Pufferwirkung der Batterie 2 zu gering und es wird eine Warnmeldung M, z.B. optisch "Batterie laden" oder "Batterie tauschen" oder akustisch, ausgegeben.

In Analogie zur schaltungstechnischen Überwachungseinheit 8 für die Spannungswelligkeit UW wird für die Stromwelligkeit IW die Spannung U über einen Shuntwiderstand, der in Reihe zur Batterie 2 geschaltet ist, abgenommen. Dabei wird die Amplitude der Stromwelligkeit IW auf Unterschreitung eines vorgegebenen Minimalwerts überwacht. Neben der Bestimmung der Welligkeiten UW und/oder IW kann auch das Verhalten von Spannung U und Strom I, insbesondere beim Einschalten eines Verbrauchers, auf Einhaltung zugehöriger Extremwerte $G_U$ bzw. $G_I$ zur Bewertung der Pufferwirkung herangezogen werden. Dazu ist schaltungstechnisch ebenfalls ein Komparator 16 vorgesehen.

Im erfindungsgemäßen Ausführungsbeispiel kann die Überwachungseinheit 8 beispielsweise als eine Rechnereinheit ausgebildet sein. Die Überwachungseinheit 8 dient dabei zur Überwachung und Bewertung der Bordnetzgrößen, d.h. der Spannung U, der Spannungswelligkeit UW, des Stroms I und/oder der Stromwelligkeit IW. Als Rechnereinheit dient beispielsweise ein Mikrocontroller oder eine andere Datenverarbeitungseinheit: Die Überwachungseinheit 8 umfaßt zur Berücksichtigung von Abhängigkeiten der Welligkeiten, wie der Stromwelligkeit IW und/oder der Spannungswelligkeit UW, Kennlinienfelder beispielsweise für Abhängigkeiten der Spannungswelligkeit UW von der Temperatur, der Generatorgleichspannung, des Generatorstroms, des Batteriestroms I. Diese Kennlinienfelder sind beispielsweise in Form von Kurven oder Tabellen hinterlegt.

Im bevorzugten Ausführungsbeispiel der Erfindung wird zusätzlich zu den vorstehend beschriebenen Messungen von Spannung U und Strom I der dynamische Innenwiderstand Ri der Batterie 2 anhand der Überwachungseinheit 8 ermittelt und zur Erkennung der Pufferwirkung verwendet. Dabei wird sowohl die Stromänderung $\Delta I$ als auch die Spannungsänderung $\Delta U$ bestimmt. Anhand des Quotienten aus Spannungsänderung $\Delta U$ und Stromänderung $\Delta I$ wird der dynamische Innenwiderstand Ri bestimmt und auf Einhaltung eines vorgegebenen zugehörigen Extremwerts $G_R$, insbesondere auf das Überschreiten eines Minimalwerts, überwacht. Wird der Minimalwert überschritten, so ist die Pufferwirkung nicht mehr ausreichend. D.h. je kleiner der Quotient aus Spannungsänderung $\Delta U$ und Stromänderung $\Delta I$ ist, desto besser ist die Pufferwirkung der Batterie 2. Bevorzugt wird der dynamische Innenwiderstand Ri bei Vorliegen einer Mindeständerung von Strom I und Spannung U, z.B. bei einer Stromänderung $\Delta I$ von mindestens 5 A und einer Spannungsänderung $\Delta U$ von mindestens 1 V, bestimmt.

Im folgenden wird nun das erfindungsgemäße Verfahren zur Bestimmung der Pufferwirkung der Batterie 2 näher beschrieben.

Beim erfindungsgemäßen Verfahren wird zyklisch, beispielsweise alle 4 ms, ein neues Wertepaar für eine Spannung U und einen Strom I der Batterie 2 bestimmt. Auf diese Weise wird die Spannungsänderung $\Delta U$ und die Stromänderung $\Delta I$ erhalten. Aus diesem Wertepaar werden durch die Überwachungseinrichtung gefilterte Werte berechnet. Als Filter wird beispielsweise ein Tiefpass 1.Ordnung bzw. VZ1-Glied verwendet. Hierbei ist bevorzugt jeweils ein schnelles Filter mit beispielsweise T = 8 ms für Spannung U und Strom I ausgebildet. Wird die Spannung zusätzlich über ein langsames Filter mit beispielsweise T = 30 ms gefiltert, können Spannungs- und Stromverlauf plausibilisiert werden und eine Vorauswahl von Spannungs- und Stromflanken getroffen werden.

Diese gefilterten Spannungs- und Stromwerte werden dann durch die Überwachungseinrichtung nach relativen Minima und Maxima durchsucht. Nach jedem erkannten Extremwert, d.h. relativen Minimum oder Maximum, wird eine Bestimmung des dynamischen Innenwiderstands Ri durchgeführt. Allerdings erfolgt diese Bestimmung des dynamischen Innenwiderstands Ri nur mit folgenden Randbedingungen:

- Vor dem erkannten Extremwert wurden bereits Startwerte infolge eines gegensätzlichen Extremwerts oder eines Ablaufs einer maximalen Wartezeit auf den nächsten Extremwert abgespeichert.
- Die Sprünge der Batteriespannung aus dem schnellen und langsamen Filter haben dasselbe Vorzeichen. Damit werden Sprünge, wie z.B. die fallende Flanke eines "Load-Dump" bzw. Lastabwurf, bei denen der Strom stark abnimmt, die Spannung hingegen nicht im selben Maße, ignoriert.
- Die Dynamik der Batteriespannungsänderung muss ein bestimmtes Mindestmaß aufweisen. Bei sehr großen Spannungssprüngen und Sprüngen, die komplett im Entladebereich liegen, reicht eine Abfrage, dass die langsame Spannungsänderung nicht größer als die schnelle Änderung ist.

Bei Sprüngen, bei denen der Strom im Entladebereich beginnt oder endet, muss der schnelle Spannungssprung 15-30% größer als der langsame Spannungssprung sein.

Sprünge, die komplett im Ladebereich liegen, müssen die höchste Dynamik aufweisen. Die schnelle Spannungsänderung muss25-50% über der langsamen Spannungsänderung liegen.

- Bei laufendem Generator wird dies dadurch erkannt, das der Spannungssprung aus dem schnellen Filter um einen bestimmten Faktor über dem des langsamen Filters liegen muss (z.B. 25%). Für sehr große Spannungssprünge (> 2V) oder bei inaktivem Generator genügt die Abfrage, dass die Differenz aus dem schnellen Filter zumindest nicht kleiner als die aus dem langsamen Filter ist.

- Das Vorzeichen von Spannungssprung und Stromsprung muss gleich sein (dU * dI > 0) oder der Strom muss unterhalb der Toleranzgrenze liegen.

Sind diese Randbedingungen erfüllt, erfolgt eine Berechnung des dynamischen Innenwiderstands Ri.

Vor der Berechnung des dynamischen Innenwiderstands Ri wird sichergestellt, dass keine Division durch Null erfolgt oder ein negativer Wert für Ri bestimmt wird. Liegt der Betrag des Stroms unterhalb der Toleranzgrenze, wird das Vorzeichen der Spannung sowie ein Mindestwert übernommen.

Die Wertigkeit der erkannten Flanke wird abhängig von dem zu erwartenden Messfehler ermittelt.

Ausgehend von der Formel

$$Ri = \frac{dU \pm 2 \times fU}{dI \pm 2 \times fI}$$

ergibt sich mit der Betrachtung für den maximalen Widerstand (gemessene Spannung groß, gemessener Strom klein):

$$Wertigkeit = abs\left( \frac{1}{1 - \dfrac{dU \times dI + 2 \times fU \times dI}{dU \times dI - 2 \times fI \times dU}} \right),$$

wobei fU und fI die zu erwartenden Fehler aus der Spannungs- bzw. Strommessung sind (z.B. Rauschen, Quantisierungsfehler durch A/D-Wandler, ...)

Die Wertigkeit ist somit aus dem relativen Fehler der Widerstandsbestimmung abgeleitet (relativer Fehler = 0...1).

Aus der Grenzwertbetrachtung ergibt sich für sehr große Spannungs- und Stromsprünge eine Wertigkeit, die gegen unendlich geht. Bei Werten, bei denen der Spannungssprung groß und der Stromsprung klein oder der Spannungssprung klein und der Stromsprung groß ist, ergibt sich eine kleine Wertigkeit, die gegen 0 geht.

Die Wertigkeit, durch 100 dividiert und auf 1 begrenzt, ergibt die Wichtung. Der dynamische Innenwiderstand Ri, der sich aus dem Quotienten aus Spannungsänderung ΔU und Stromänderung ΔI ergibt, wird mittels dieses Wichtungsfaktors gewichtet.

Somit würde ein Messwert mit einem zu erwartenden Fehler von kleiner 1% sofort übernommen werden.

Für die weitere Berechnung werden nur solche Werte des dynamischen Innenwiderstands Ri berücksichtigt, bei denen eine der folgenden Bedingungen erfüllt ist:

- Die Wichtung weist auf einen ausreichend kleinen Messfehler hin.
- Der Spannungssprung ist sehr groß.
- Der Stromsprung ist sehr groß.

Durch die alternative Berechnung bei großem Spannungs- oder Stromsprung ist es auch möglich, sehr kleine oder große Widerstandswerte (allerdings mit hoher Fehlerwahrscheinlichkeit) zu berechnen.

Der neue, gefilterte Wert des dynamischen Innenwiderstands Ri ergibt sich aus den alten Werten und dem entsprechend gewichteten, neuen Wert nach der Formel:

RiFilt = RiFilt x (1 - WichtungFlanke) + RiFlanke x WichtungFlanke

In der Anfangsphase ist die Summe aller bisher erfolgten Gewichtungen kleiner als 1. In diesem Fall wird die Gewichtung der aktuellen Flanke auf die Summe der vorhandenen Gewichtungen bezogen und dieser relative Wert als aktuelle Flankengewichtung herangezogen. Je geringer die Summe der vorhandenen Gewichtungen ist und je größer die Gewichtung der aktuellen Flanke ist, desto stärker wird dieses somit berücksichtigt.

Zusätzlich zu der normalen Berechnung wird noch ein "schneller dynamischer Innenwiderstand Ri-schnell" berechnet. Dieser setzt sich nur aus den letzten 20 berechneten Werten zusammen und weist somit eine deutlich höhere Dynamik und Ungenauigkeit als der gefilterte dynamische Innenwiderstand Ri auf. Bei großen Abweichungen zwischen dem gefilterten dynamischen Innenwiderstand Ri und dem schnellen dynamischen Innenwiderstand Ri-schnell wird der schnelle dynamische Innenwiderstand Ri-schnell übernommen, wenn er ausreichend stabil ist und einer der Werte (gefiltert oder schnell) über einem bestimmten Mindestwert liegt. Werden sehr lange keine Werte des dynamischen Innenwiderstands Ri bestimmt, wird der schnelle dynamische Innenwiderstand Ri-schnell zurückgesetzt, um bei erneuter Anregung schneller Werte zu liefern.

Zur Bewertung der Aussagekraft wird die Zeit gemessen, die erforderlich ist, um den schnellen dynamischen Innenwiderstand Ri-schnell zu berechnen. Ist hier eine vorbestimmte Zeitspanne abgelaufen, kann die Aussagekraft als nicht mehr ausreichend angenommen werden.

Eine Aussage über die Pufferwirkung der Batterie 2 wird aus der Aussagekraft und dem ermittelten dynamischen Innenwiderstand Ri getroffen.

Für die Aussage über die Pufferwirkung der Batterie 2 existieren zwei Ausgangsgrößen:

1. Ein erstes Ausgangssignal A1, das immer eine Wert liefert, auch wenn die Anregung nicht mehr ausreichend ist. Dieser Wert wird benötigt, um immer eine Aussage über die Pufferwirkung der Batterie 2 zu erhalten. Wenn die Anregung nicht mehr ausreichend ist, behält dieses Ausgangssignal den letzten ermittelten Wert. Neue Werte werden erst wieder ermittelt, wenn die Aussagekraft ausreichend ist.

2. Ein zweites Ausgangssignal A2, das nur einen Wert liefert, wenn die Aussagekraft ausreichend ist. Ist dies nicht mehr der Fall, erhält das Ausgangssignal den Wert für "nicht verfügbar".

Eine Aktualisierung der Aussage über die Pufferwirkung der Batterie erfolgt immer, wenn ein neuer dynamischer Innenwiderstand Ri ermittelt wurde und die Aussagekraft ausreichend ist.

Die Bildung der Ausgangsgröße erfolgt zweistufig. Zuerst werden drei Bereiche unabhängig voneinander beurteilt. Anschließend erfolgt eine Abfrage der Bereiche und Bildung der Ausgangsgrößen.

Es gibt mehrere entscheidende Bereiche, in denen sich der dynamische Innenwiderstand Ri bewegen kann. Diese werden unabhängig voneinander nach dem selben Prinzip, aber unterschiedlichen Parametern (Schwellen und Zeiten) bewertet. Für jeden Bereich existiert eine obere und untere Schwelle sowie eine Mindestzeit für die Überschreitung der oberen Schwelle und eine Mindestzeit für die Unterschreitung der unteren Schwelle. Dies kommt daher, dass die Berechnung des dynamischen Innenwiderstands bei sehr kleinen Werten (< 20mΩ) ungenauer erfolgt als beispielsweise bei 80mΩ. Außerdem muss die Erkennung des kritischen Batteriezustandes schneller erfolgen als z.B. der Fremdstartfall.

Als Schwellen für den dynamischen Innenwiderstand Ri ist ein oberer und ein unterer Schwellenwert Tho bzw. Thu festgelegt. Zusätzlich sind noch zwei Zeitspannen To bzw. Tu festgelegt, während derer die Schwellen durch den dynamischen Innenwiderstand Ri überschritten sein müssen, bevor sich der Zustand für den entsprechenden Bereich ändert.

Wird nach einem Zurücksetzen erstmalig ein aussagekräftiger Wert für den dynamischen Innenwiderstand Ri ermittelt, wird für die Pufferwirkung in jedem Fall ein Wert angenommen. Dieser ist Ri-unter, wenn der Wert unterhalb des oberen Schwellenwerts liegt, sonst Ri-über. Dieses Verfahren wurde gewählt, da sonst bei einem ermittelten dynamischen Innenwiderstand Ri zwischen den beiden Schwellenwerten für längere Zeit keine Aussage möglich wäre und sich im Normalfall der Batteriezustand bessert. Außerdem wird im besseren Fall keine Meldung erzeugt.

Eine Änderung der entsprechenden Bereichsgröße ergibt sich anschließend nur, wenn:

- bei schlechtem Zustand der dynamische Innenwiderstand Ri für länger als Tu unterhalb von Thu ist; dann wird die Pufferwirkung auf Ri-unter gesetzt.

- bei gutem Zustand der dynamische Innenwiderstand Ri für länger als To oberhalb von Tho ist; dann wird die Pufferwirkung auf Ri-über gesetzt.

Es werden verschiedene Schwellen und Zeiten, aufgrund verschiedenen zu verwendender Batteriegrößen und Technologien als Wertebereich angegeben, für die Bildung von einzelnen Bereichsbits verwendet, wie in Tabelle 1 gezeigt, so dass zwischen einer Schwelle für einen kritischen Bordnetzzustand, einer Schwelle für die Einleitung von Zusatzmaßnahmen, z.B. einer Zuschaltung einer zweiten Batterie (Stützbatterie) bat2 und einer Schwelle für einen Fremdstart fs unterschieden werden kann.

Tabelle 1

|  | Tho[mΩ] | Thu[mΩ] | To[s] | Tu[s] | Bemerkung |
|---|---|---|---|---|---|
| Ri-krit | 220-130 | 140-90 | 0,5-3 | 0,3-3 | Schwelle für kritischen Bordnetzzustand |
| Ri-bat2 | 90-20 | 50-15 | 3-20 | 3-20 | Schwelle für Einleitung von Zusatzmaßnahmen, z.B. Zuschaltung einer zweiten Batterie |
| Ri-fs | 30-15 | 20-8 | 10-40 | 10-40 | Schwelle für einen Fremdstart |

Nachdem die einzelnen Bereichsbits gebildet wurden, werden diese zusammen mit der Information über die Aussagekraft verwendet, um die Ausgangsgrößen A1 bzw. A2 zu bilden.
Die logische Verknüpfung dieser Bereichsbits ist in nachfolgender Tabelle 2 dargestellt:

Tabelle 2

| Ri-krit | Ri-bat2 | Ri-fs | Aussagekraft OK | A1 | A2 |
|---|---|---|---|---|---|
| 0 | 0 | 0 | 0 | A1-io | A2-nv |
| 0 | 0 | 0 | 1 | A1-io | A2-io |
| 0 | 0 | 1 | 0 | A1-fs | A2-nv |
| 0 | 0 | 1 | 1 | A1-fs | A2-io |
| 0 | 1 | 0 | 0 | A1-bat2 | A2-nv |
| 0 | 1 | 0 | 1 | A1-bat2 | A2-bat2 |
| 0 | 1 | 1 | 0 | A1-bat2 | A2-nv |
| 0 | 1 | 1 | 1 | A1-bat2 | A2-bat2 |
| 1 | 0 | 0 | 0 | A1-krit | A2-nv |
| 1 | 0 | 0 | 1 | A1-krit | A2-krit |
| 1 | 0 | 1 | 0 | A1-krit | A2-nv |
| 1 | 0 | 1 | 1 | A1-krit | A2-krit |
| 1 | 1 | 0 | 0 | A1-krit | A2-nv |
| 1 | 1 | 0 | 1 | A1-krit | A2-krit |
| 1 | 1 | 1 | 0 | A1-krit | A2-nv |
| 1 | 1 | 1 | 1 | A1-krit | A2-krit |

wobei A1-io gleich Pufferwirkung in Ordnung, Al-fs gleich Pufferwirkung im Fremdstartbereich, Al-bat2 gleich Pufferwirkung im Bereich, dass die zweite Batterie zugeschaltet werden sollte, A1-krit gleich Pufferwirkung kritisch, A2-io gleich Pufferwirkung in Ordnung, A2-fs gleich Pufferwirkung im Fremdstartbereich, A2-bat2 gleich Pufferwirkung im Bereich, dass die zweite Batterie zugeschaltet werden sollte, A2-krit gleich Pufferwirkung kritisch und A2-nv gleich Wert für Pufferwirkung nicht verfügbar ist.
Um in Phasen, in denen eine aussagekräftige Bestimmung des dynamischen Innenwiderstands Ri erforderlich ist, ausreichend Anregung für diese zu bekommen, ist es in einer bevorzugten Weiterbildung der Erfindung vorgesehen, gegebenenfalls die heizbare Heckscheibe zu verwenden, um zusätzliche Flanken zu bekommen. Hierzu erfolgt eine gezielte Ansteuerung der heizbaren Heckscheibe, wobei jedoch die folgenden Randbedingungen erfüllt sein müssen, dass eine Anregung durch die heizbare Heckscheibe generiert wird:

-   Der aktuell ermittelte Wert für den dynamischen Innenwiderstand Ri muss über einem bestimmten Wert liegen.
-   Der Generator muss aktiv sein.
-   Die aktuelle Anregung ist nicht ausreichend.
-   Es muss eine Mindestzeit Tmin seit Beendigung des letzten Anregungsimpulses vergangen sein.

Wenn diese Randbedingungen erfüllt sind, wird durch eine Ansteuereinrichtung in der Überwachungseinrichtung zunächst die heizbare Heckscheibe deaktiviert, wenn sie in Betrieb ist. Nach Ablauf einer Verzögerungszeit T-HSSaus wird die heizbare Heckscheibe (wieder) aktiviert. Anschließend wird eine zweite Verzögerungszeit T-HSSein abgewartet, nach deren Ablauf die heizbare Heckscheibe wieder der normalen Steuerung durch die Ansteuereinrichtung übergeben wird.

Auf diese Weise wird erreicht, dass der dynamische Innenwiderstand Ri auch im Fall einer normalerweise fehlenden Anregung zuverlässig und einfach bestimmt werden kann, so dass eine Aussage über die Pufferwirkung der Batterie 2 problemlos möglich ist.

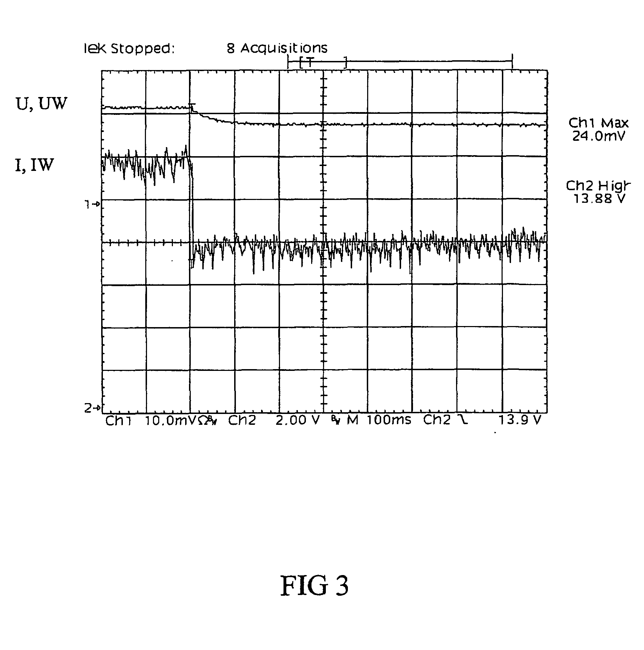

Im weiteren werden anhand von Diagrammen verschiedene Messungen an der Batterie 2 dargestellt und deren Auswirkungen auf die Pufferwirkung der Batterie 2 näher erläutert. In Figur 3 ist ein Diagramm für eine Strom-Spannungs-Kennlinie einer geladenen Batterie 2 beispielhaft dargestellt. Die obere Kurve stellt die Spannung U, die untere Kurve den Strom I der Batterie 2 dar. Die Spannungswelligkeit UW ist trotz pulsartiger Stromänderung $\Delta$I sehr gering. Somit weist die Batterie 2 eine weitgehend gute Pufferwirkung auf. Die Spannungswelligkeit UW wird dabei, wie oben dargelegt, anhand der Anordnung 1 auf Einhaltung des vorgegebenen Grenzwerts $G_{UW}$ überwacht.

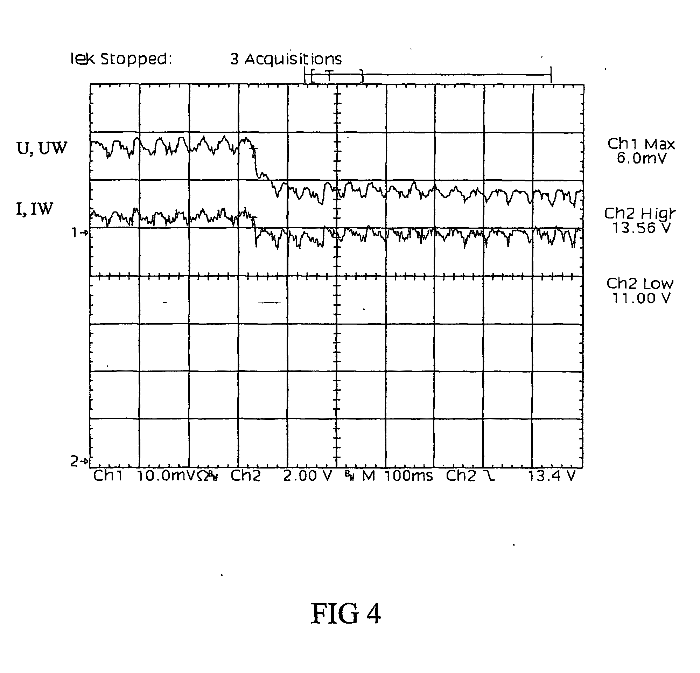

In Figur 4 ist beispielhaft für eine Messung bei einer stark entladenen Batterie 2 eine Strom-Spannungs-Kennlinie dargestellt. Diese hat keine Pufferwirkung mehr. Die Spannungswelligkeit UW (obere Kurve) ist gegenüber der Messung in Figur 3 deutlich größer und ist somit ein Indiz für eine nicht ausreichende Pufferwirkung der Batterie 2.

Neben der Bestimmung und Erfassung sowie Überwachung der Spannungswelligkeit UW und/oder der Stromwelligkeit IW kann auch das Verhalten der Bordnetzspannung U und des Bordnetzstroms I, insbesondere beim Einschalten einer Last, zur Bewertung der Pufferwirkung der Batterie 2 herangezogen werden, wie vorstehend bereits erläutert.

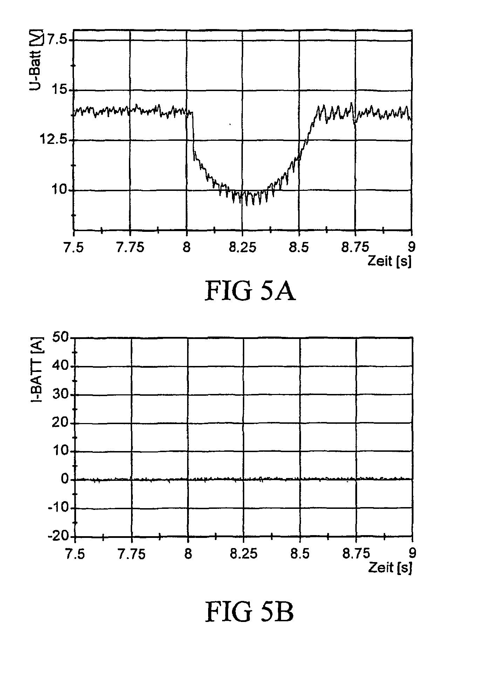

In den Figuren 5A und 5B ist der Spannungsverlauf (oben) bzw. der Stromverlauf (unten) während des Einschaltens eines Verbrauchers, z.B. der Heckscheibenheizung, dargestellt. Die Messung wurde ohne Batterie 2 durchgeführt, d.h., eine Pufferwirkung der Batterie 2 war nicht gegeben. Da keine Batterie 2 vorhanden ist, fließt auch kein Batteriestrom I, der gesamte Strom I muß vom Generator 5 bereitgestellt werden. Durch den plötzlichen Anstieg des Stromes I im Bordnetz 4, bricht die Spannung U zunächst ein, ein generatorinterner Regler regelt die Spannung U innerhalb von ca. 600 ms wieder auf ihren Sollwert hoch.

Das Einschalten des Verbrauchers, hier der Heckscheibenheizung, wird dabei mittels des Spannungssensors 6 und des Stromsensors 10 oder alternativ über ein Signal über einen Datenbus ermittelt. Nach dem Einschalten wird der anhand des Spannungssensors 6 und des Stromsensors 10 ermittelte Spannungseinbruch bzw. der Stromverlauf mittels der Überwachungseinheit 8, schaltungstechnisch und/oder in Software, bewertet. Aus dem Stromverlauf lässt sich erkennen, wann der Verbraucher eingeschaltet ist. Aus dem zugehörigen Spannungsverlauf wird auf die Pufferwirkung geschlossen. Bricht die Spannung U unter einen vorgegebenen Grenzwert $G_U$ ein, z.B. 12,5 V, so wird hieraus geschlossen, dass die Pufferwirkung der Batterie 2 nicht mehr ausreichend ist.

Weiterhin kann aus der Stromänderung $\Delta$I die Stromaufnahme des Verbrauchers abgeschätzt werden. Ist die Stromänderung $\Delta$I deutlich geringer als der Nennstrom des Verbrauchers, so kann die Batterie 2 nicht mehr ausreichend Strom I liefern. Dabei wird die Erfassung der Spannung U und des Stroms I fortlaufend, insbesondere unmittelbar nach Einschalten der Last innerhalb der Regelzeit des Generators 5, ausgeführt. Für einen Test kann durch ein mehrfaches Ein-/Ausschalten des Verbrauchers sichergestellt werden, dass die Messung nicht von einem zufällig einschaltenden, weiteren Verbraucher überlagert wird und die Messung falsche Aussagen liefert.

Wie vorstehend bereits näher erläutert kann anhand der Spannungsänderung $\Delta$U und der Stromänderung $\Delta$I der dynamische Innenwiderstand bestimmt werden. Die Bestimmung des Quotienten $\Delta$U/$\Delta$I erfolgt, wie oben bereits dargelegt, ab einer wesentlichen Strom- und Spannungsänderung, z.B. von $\Delta$U=1V oder von $\Delta$I=5A, im Bordnetz 4. Dabei wird mittels der Überwachungseinheit 8 der Quotient aus Spannungsänderung $\Delta$U und der Stromänderung $\Delta$I auf einen vorgegebenen Grenzwert $G_R$ überwacht. Je kleiner der Quotient aus $\Delta$U/$\Delta$I ist, desto besser ist die Pufferwirkung der Batterie 2. Hierzu wird der Grenzwert $G_R$, insbesondere ein Minimalwert, auf Überschreitung überwacht.

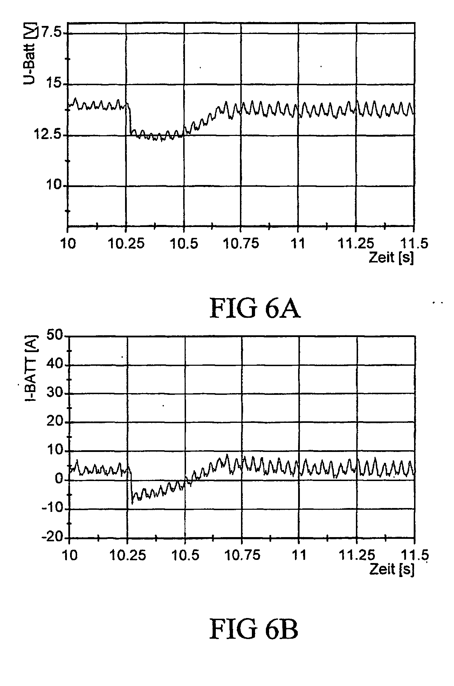

In den Figuren 6A und 6B ist die gleiche Messung, wie nach Figuren 5A und 5B, aber mit einer defekten, d. h. nur begrenzt pufferfähigen, Batterie 2 ausgeführt worden. Zunächst wird die Batterie 2 bis zum Zeitpunkt t = 10,25 s geladen, danach wird die Heckscheibenheizung eingeschaltet. Der Strom I wird negativ. Dabei wird nicht der gesamte, zum Betrieb der Heckscheibenheizung erforderliche Strom I aus der Batterie 2 entnommen. Der Stromsprung im Batteriestrom I nach Einschalten der Heckscheibenheizung oder der Last ist geringer als der eigentliche Strom (Nennstrom) der Heckscheibenheizung. Dadurch bricht die Spannung U am Generator 5 weitgehend, d.h. bis auf U = 12.5 Volt, ein. Der Generator 5 regelt die Spannung U mit einer entsprechenden Zeitkonstante wieder nach. Hierbei kann mittels der Überwachungseinheit 8 die hohe Spannungswelligkeit UW oder der geringere Stromsprung und der hohe Spannungseinbruch als Kriterium für eine schlechte Pufferwirkung der Batterie 2 herangezogen werden.

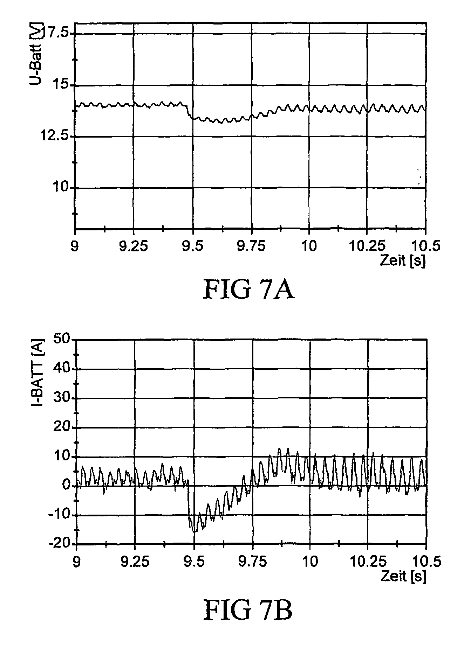

In den Figuren 7A und 7B ist die Strom-Spannungs-Kennlinie für die gleiche Messung wie nach den Figuren 6A und 6B, aber mit einer gegenüber der betreffenden Batterie pufferfähigeren Batterie 2 dargestellt. Zunächst wird die Batterie 2 bis zum Zeitpunkt t = 9,5 s geladen, danach wird die Heckscheibenheizung eingeschaltet. Der Strom I wird negativ. Dabei wird gegenüber der Figur 6B mehr Strom I zum Betrieb der Heckscheibenheizung aus der Batterie 2 entnommen. Dadurch bricht die Spannung U am Generator 5 geringer, d.h. bis auf U=13,25 Volt, ein. Der Generator 5 regelt die Spannung mit der entsprechenden Zeitkonstante wieder nach. Auch hier kann mittels der Überwachungseinheit 8 die hohe Spannungswelligkeit UW oder der geringere Stromsprung und der hohe Spannungseinbruch als Kriterium für eine schlechte Pufferwirkung herangezogen werden.

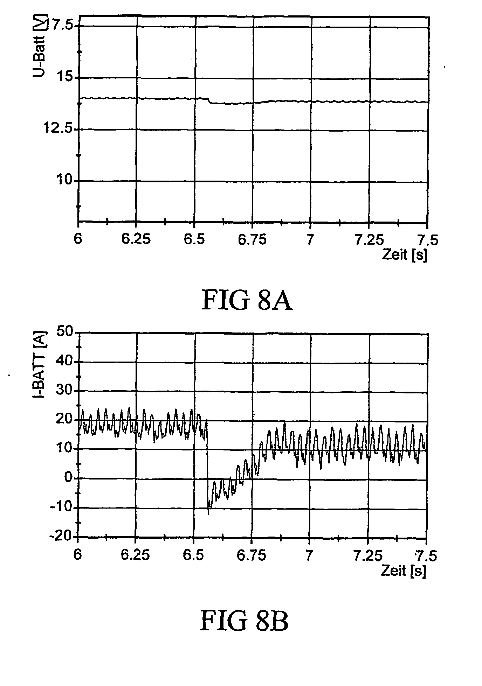

Demgegenüber ist in den Figuren 8A und 8B die Strom-Spannungs-Kennlinie für die gleiche Messung mit einer voll pufferfähigen Batterie 2 dargestellt. Es ist deutlich zu erkennen, dass die Spannungswelligkeit UW gegenüber den Figuren 5A, 5B bis 7A, 7B wesentlich geringer ist. Zunächst wird die Batterie 2 bis zum Zeitpunkt t = 6,6 s geladen, danach wird die Heckscheibenheizung eingeschaltet. Der Strom I wird negativ, es kann nahezu der gesamte Strom I für die Heckscheibenheizung aus der Batterie 2 entnommen werden. Dadurch bricht die Spannung U am Generator nur um ca. 150-200 mV ein. Mittels der Überwachungseinheit 8 wird anhand der geringeren Spannungswelligkeit UW eine weitgehend gute Pufferwirkung der Batterie 2 ermittelt.

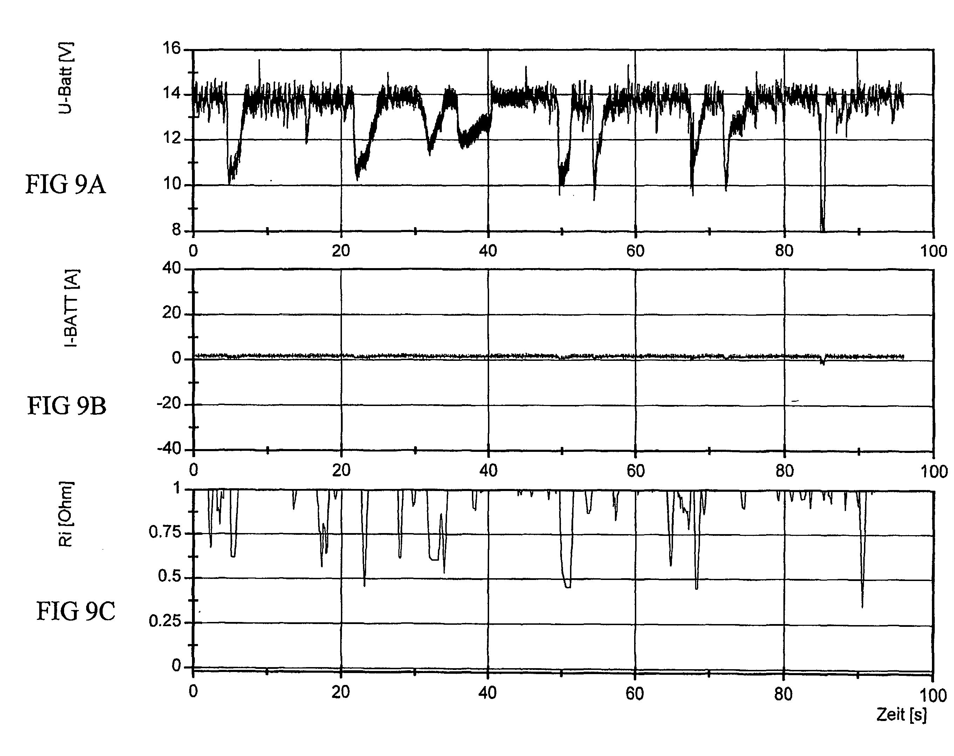

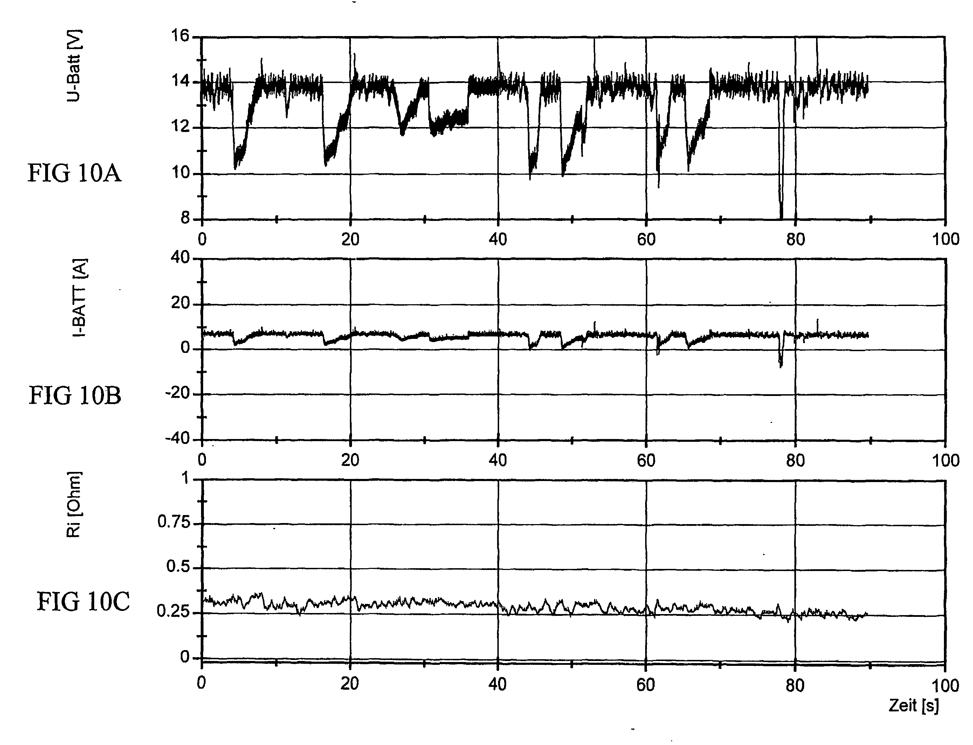

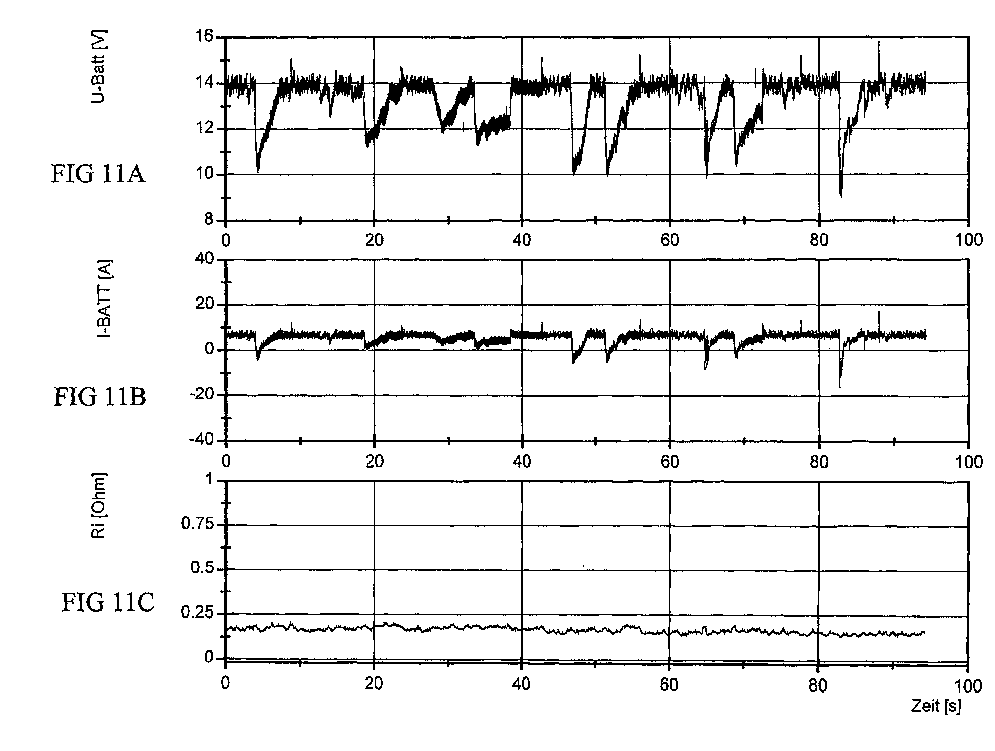

In den Figuren 9A-C bis 11A-C sind die Strom-Spannungs-Kennlinie sowie die Kennlinie für den dynamischen Innenwiderstand Ri an einer tiefentladenen Batterie 2, welche aufgetaut wird, dargestellt. In den Figuren 9A bis 9C ist die Batterie 2 noch stark gefroren, sie nimmt keine Ladung auf, d.h. der Strom I = 0. Mittels der Überwachungseinheit 8 wird in diesem Zustand insbesondere der dynamische Innenwiderstand Ri überwacht, der mit Ri größer 1 Ω sehr hoch ist. Somit hat die Batterie 2 keine Pufferwirkung. Die Figuren 10A bis 10C zeigen die Kennlinien für dieselbe Batterie 2 nach ca. 18.6 h des Auftauens. Dabei nimmt die Batterie 2 Strom I auf. Der dynamische Innenwiderstand Ri ist auf einen Wert zwischen 250 bis 350 mΩ gesunken. Somit wird mittels der Überwachung des dynamischen Innenwiderstands Ri anhand der Überwachungseinheit 8 eine Pufferwirkung identifiziert, da der dynamische Innenwiderstand Ri den zugehörigen Grenzwert $G_R$ unterschritten hat. Nachdem die Batterie 7 Minuten lang geladen worden ist, sinkt der dynamische Innenwiderstand Ri auf einen Wert unterhalb von 250 mΩ. Die zugehörigen Kennlinien sind in den Figuren 11A bis 11C dargestellt.

In den Figuren 11A bis 11C sind die Strom-Spannungs-Kennlinie und die Kennlinie für den dynamischen Innenwiderstand Ri einer vollgeladenen Batterie 2 mit einer maximalen Pufferwirkung dargestellt. Der dynamische Innenwiderstand Ri ist auf einen Wert von 10 bis 20 mΩ gesunken.

Je nach Art und Ausführung der Anordnung 1 können zur Bestimmung der Pufferwirkung der Batterie 2 die Spannungswelligkeit UW oder der Spannungseinbruch getrennt oder kombiniert überwacht werden. Desweiteren sind weitere, beliebige Kombinationen der Überwachung von Stromwelligkeit IW, Stromeinbruch I, Spannungseinbruch U und/oder vom dynamischen Innenwiderstand Ri auf Einhaltung von Grenzwerten G möglich.

Zusammenfassend offenbart die vorliegende Erfindung für eine möglichst einfache und sichere Erkennung der Funktionsfähigkeit einer Batterie ein Verfahren zur Bestimmung der Pufferwirkung der Batterie (2) zur Bereitstellung einer Spannung (U) für ein Bordnetz (4), insbesondere eines Fahrzeugs, bei dem eine Spannungsänderung und eine Stromänderung zyklisch erfasst werden, der dynamische Innenwiderstand der Batterie anhand des Quotienten aus der Spannungsänderung und der Stromänderung bestimmt wird, der bestimmte dynamische Innenwiderstand auf Überschreitung eines vorgebbaren Grenzwerts überwacht wird und eine Aussage über die Pufferwirkung der Batterie getroffen und ausgegeben wird. Dabei ist die Pufferwirkung der Batterie um so besser, je kleiner der Quotient aus Spannungsänderung und Stromänderung ist.

**Patentansprüche**

1. Verfahren zur Bestimmung der Pufferwirkung einer Batterie (2) zur Bereitstellung einer Spannung (U) für ein Bordnetz (4), insbesondere eines Fahrzeugs,
   mit den Schritten
   zyklisches Erfassen einer Spannungsänderung (ΔU) und einer Stromänderung (ΔI),
   Filtern der Werte der erfassten Spannungsänderung (ΔU) und Stromänderung (ΔI) und Durchsuchen der gefilterten Werte durch die Überwachungseinrichtung (8) nach relativen Extremwerten, d.h. relativen Minima und relativen Maxima,
   Bestimmen des dynamischen Innenwiderstands (Ri) der Batterie (2) anhand des Quotienten aus der Spannungsänderung (ΔU) und der Stromänderung (ΔI) bei den beim Durchsuchen gefundenen Extremwerten, wenn vorgegebene Randbedingungen erfüllt sind,
   Überwachen des bestimmten dynamischen Innenwiderstands (Ri) auf Überschreitung eines vorgebbaren Grenzwerts ($G_R$) durch die Überwachungseinrichtung (8) und
   Treffen einer Aussage über die Pufferwirkung der Batterie (2) und Ausgeben dieser Aussage über die Pufferwirkung der Batterie (2), wobei die Pufferwirkung der Batterie (2) um so besser ist, je kleiner der Quotient aus Spannungsänderung (ΔU) und Stromänderung (ΔI) ist.

2. Verfahren nach Anspruch 1,

**dadurch gekennzeichnet, dass**
der vorgebbare Grenzwert ($G_R$) ein Minimalwert bzw. Maximalwert ist.

3. Verfahren nach Anspruch 1 oder 2,
**dadurch gekennzeichnet, dass**
die erfassten Strom- und/oder Spannungsänderungen durch mehrere parallele Filter mit unterschiedlichen Zeitkonstanten bearbeitet werden und der Vergleich der Ausgangssignale der Filter als Freigabesignal für die Berechnung des Innenwiderstands genutzt wird.

4. Verfahren nach einem der Ansprüche 1 bis 3,
**dadurch gekennzeichnet, dass**
Entscheidungskriterien beim Vergleich der Ausgangssignale der Filter abhängig vom Bordnetzzustand (Laden der Batterie, Entladen der Batterie, Übergangszustand) und/oder von der Höhe der Strom- oder Spannungsänderung ist.

5. Verfahren nach einem der Ansprüche 1 bis 4,
**dadurch gekennzeichnet, dass**
aus dem relativen Fehler der Widerstandsbestimmung eine Wertigkeit abgeleitet wird, die durch 100 dividiert und auf 1 begrenzt einen Wichtungsfaktor für den dynamischen Innenwiderstand Ri ergibt.

6. Verfahren nach Anspruch 5,
**dadurch gekennzeichnet, dass**
ein neuer, gefilterter Wert des dynamischen Innenwiderstands (Ri) aus bereits vorher gespeicherten, alten Werten für den dynamischen Innenwiderstand (Ri) und dem entsprechend dem Wichtungsfaktor gewichteten, neue bestimmten Wert für den dynamischen Innenwiderstand (Ri) bei aufgefundenen Grenzwert bestimmt wird.

7. Verfahren nach Anspruch 5,
**dadurch gekennzeichnet, dass**
für eine schnelle Beurteilung des dynamischen Innenwiderstands nur die letzten 20 berechneten Werte des dynamischen Innenwiderstands ausgewertet werden.

8. Verfahren nach Anspruch 6,
**dadurch gekennzeichnet, dass**
die Aussage über die Pufferwirkung der Batterie (2) immer dann aktualisiert wird, wenn ein neuer dynamischer Innenwiderstand Ri ermittelt wurde.

9. Verfahren nach einem der vorhergehenden Ansprüche 1 bis 8,
**dadurch gekennzeichnet, dass**
für den dynamischen Innenwiderstand (Ri) ein oberer und unterer Schwellenwert (Tho, Thu) sowie zwei Zeitspannen (To, Tu) festgelegt sind, während derer die Schwellen durch den dynamischen Innenwiderstand (Ri) überschritten (To) oder unterschritten (Tu) sein müssen, damit eine Aussage über die Pufferwirkung der Batterie (2) ausgegeben wird.

10. Verfahren nach Anspruch 9,
**dadurch gekennzeichnet, dass**
die Schwellenwerte und Zeitspannen für verschiedene Bereiche jeweils verschieden gesetzt werden, so dass zwischen einer Schwelle und Zeitspannung für einen kritischen Bordnetzzustand, einer Schwelle und Zeitspanne für eine zusätzliche Maßnahme, z.B. eine Zuschaltung einer zweiten Batterie, und einer Schwelle und Zeitspanne für einen Fremdstart unterschieden werden kann.

11. Verfahren nach einem der vorhergehenden Ansprüche 1 bis 10,
**dadurch gekennzeichnet, dass**,
wenn eine Anregung nicht ausreichend für eine aussagekräftige Bestimmung des dynamischen Innenwiderstands (Ri) ist, durch eine gezielte Ansteuerung eines Verbrauchers, zusätzliche Grenzwerte erzeugt werden.

12. Verfahren nach Anspruch 11,
**dadurch gekennzeichnet, dass**
als Verbraucher eine heizbare Heckscheibe angesteuert wird.

**13.** Verfahren nach einem der vorhergehenden Ansprüche 1 bis 12,
**gekennzeichnet durch** den weiteren Schritt Ausgeben einer Warnmeldung (M) bei Überschreiten des Grenzwerts ($G_R$).

**14.** Anordnung zur Bestimmung der Pufferwirkung einer Batterie (2) zur Bereitstellung einer Spannung (U) für ein Bordnetz (4), insbesondere eines Fahrzeugs,
**dadurch gekennzeichnet, dass**
Mittel (6, 10) zur Erfassung und Bestimmung der Spannung und des Stroms sowie eine Überwachungseinheit (8) zum Filtern einer durch die Mittel (6, 10) zur Erfassung und Bestimmung der Spannung und des Stroms erfassten Spannungsänderung ($\Delta U$) und Stromänderung ($\Delta I$) und zur anschließenden Durchsuchung nach relativen Extremwerten und zur Bestimmung des dynamischen Innenwiderstands der Batterie (2) anhand des Quotienten aus Spannungsänderung ($\Delta U$) und Stromänderung ($\Delta I$) bei den bei der Durchsuchung gefundenen relativen Extremwerten, wenn vorgegebene Randbedingungen erfüllt sind, Überwachung des bestimmten dynamischen Innenwiderstands (Ri) auf Überschreitung eines vorgebbaren Grenzwerts ($G_R$) und Treffen einer Aussage über die Pufferwirkung der Batterie (2) und Ausgabe dieser Aussage über die Pufferwirkung der Batterie (2) vorgesehen ist.

**15.** Anordnung nach Anspruch 14,
**dadurch gekennzeichnet, dass**
die Überwachungseinrichtung (8) eine Einrichtung zur gezielten Ansteuerung eines Verbrauchers aufweist, wenn keine ausreichende Anregung zur Ermittlung des dynamischen Innenwiderstands (Ri) vorliegt.

**Claims**

**1.** A process for determining the buffer effect of a battery (2) for the provision of a voltage (U) for an electrical system (4), in particular in a vehicle, having the following steps:

- the cyclical measurement of a change in voltage ($\Delta U$) and a change in current ($\Delta I$),
- the filtering of the values for the change in voltage ($\Delta U$) and the change in current ($\Delta I$) measured and the searching of the filtered values by the monitoring device (8) for relative extreme values, i.e. relative minimum values and relative maximum values,
- the determination of the dynamic internal resistance (Ri) of the battery (2) using the quotient from the change in voltage ($\Delta U$) and the change in current ($\Delta I$) at the extreme values found during the search if predetermined boundary conditions are fulfilled,
- the monitoring of the dynamic internal resistance (Ri) determined to ascertain whether it exceeds a predetermined limit value ($G_R$) by the monitoring device (8) and
- the drawing of a conclusion as to the buffer effect of the battery (2) and the outputting of this conclusion as to the buffer effect of the battery (2), the buffer effect of the battery (2) being better, the smaller the quotient from the change in voltage ($\Delta U$) and the change in current ($\Delta I$).

**2.** A process in accordance with claim 1,
**characterised in that**
the predeterminable limit value ($G_R$) is a minimum value or a maximum value.

**3.** A process in accordance with claim 1 or 2,
**characterised in that**
the changes in current and/or voltage measured are processed by several parallel filters with different time constants and the comparison of the signals output by the filters is used as an enabling signal for the calculation of the internal resistance.

**4.** A process in accordance with one of claims 1 to 3,
**characterised in that**
decision-making criteria in the comparison of the signals output by the filters are dependent on the status of the electrical system (battery charging, battery discharging, transitional status) and/or on the extent of the change in current or voltage.

**5.** A process in accordance with one of claims 1 to 4,
**characterised in that**

a weighting is derived from the relative error of the resistance determination which, when divided by 100 and limited to 1, gives a weighting factor for the dynamic internal resistance (Ri).

6. A process in accordance with claim 5,
**characterised in that**
a new, filtered value for the dynamic internal resistance (Ri) is determined from old, previously stored values for the dynamic internal resistance (Ri) and from the newly determined value for the dynamic internal resistance (Ri) weighted according to the weighting factor when the limit value is found.

7. A process in accordance with claim 5,
**characterised in that**
for a fast assessment of the dynamic internal resistance, only the last 20 values calculated for the dynamic internal resistance are evaluated.

8. A process in accordance with claim 6,
**characterised in that**
the conclusion as to the buffer effect of the battery (2) is updated whenever a new dynamic internal resistance (Ri) has been determined.

9. A process in accordance with one of the preceding claims 1 to 8 ,
**characterised in that**
an upper and a lower threshold value (Tho, Thu) and two periods of time (To, Tu) are set for the dynamic internal resistance (Ri) during which the dynamic internal resistance (Ri) must be above (To) or below (Tu) the thresholds in order to enable a conclusion as to the buffer effect of the battery (2) to be output.

10. A process in accordance with claim 9,
**characterised in that**
the threshold values and periods of time for different areas are set differently so that it is possible to distinguish between a threshold and a period of time for a critical electrical system status, a threshold and a period of time for an additional measure, e.g. the connection of a second battery, and a threshold and a period of time for a jump start.

11. A process in accordance with one of the preceding claims 1 to 10,
**characterised in that**
if an excitation is not sufficient for the conclusive determination of the dynamic internal resistance (Ri), by the controlled actuation of a consumer, additional limit values are generated.

12. A process in accordance with claim 11,
**characterised in that**
a heated rear-window is actuated as the consumer.

13. A process in accordance with one of the preceding claims 1 to 12,
**characterised by**
the further step of the outputting of a warning message (M) when the limit value ($G_R$) is exceeded.

14. An arrangement for determining the buffer effect of a battery (2) for the provision of a voltage (U) for an electrical system (4), in particular in a vehicle,
**characterised in that**
there are provided means (6, 10) for measuring and determining the voltage and the current and a monitoring unit (8) for filtering a change in voltage ($\Delta U$) and a change in current ($\Delta I$) measured by the means (6, 10) for measuring and determining the voltage and the current, for the subsequent searching for relative extreme values, for determining the dynamic internal resistance (Ri) of the battery (2) using the quotient from the change in voltage ($\Delta U$) and the change in current ($\Delta I$) at the extreme values found during the search if predetermined boundary conditions are fulfilled, for monitoring the given dynamic internal resistance (Ri) to ascertain whether it exceeds a predetermined limit value ($G_R$), for drawing a conclusion as to the buffer effect of the battery (2) and outputting this conclusion as to the buffer effect of the battery (2).

15. A process in accordance with claim 14,
**characterised in that**

the monitoring device (8) has a device for the controlled actuation of a consumer when there is insufficient excitation to measure the dynamic internal resistance (Ri).

**Revendications**

1. Procédé pour déterminer l'effet tampon d'une batterie (2) pour la mise à disposition d'une tension (U) pour un réseau de bord (4), en particulier d'un véhicule, comprenant les étapes de :

   - saisie cyclique d'une modification de tension ($\Delta U$) et d'une modification du courant ($\Delta I$) ;
   - filtrage des valeurs de la modification de tension saisie ($\Delta U$) et de la modification du courant saisie ($\Delta I$) et recherche des valeurs filtrées par le dispositif de surveillance (8) selon des valeurs relatives extrêmes, c'est-à-dire des minimums et des maximums relatifs ;
   - détermination de la résistance intérieure dynamique (Ri) de la batterie (2) selon le quotient formé par la modification de tension ($\Delta U$) et la modification du courant ($\Delta I$) avec les valeurs relatives extrêmes trouvées lors de la recherche lorsque des conditions marginales prescrites sont remplies ;
   - surveillance de la résistance intérieure dynamique (Ri) déterminée quant au dépassement d'une valeur limite pouvant être prescrite ($G_R$) par le dispositif de surveillance (8) ; et
   - conclusion d'une affirmation sur l'effet tampon de la batterie (2) et sortie de cette affirmation sur l'effet tampon de la batterie (2),

   sachant que plus le quotient formé par la modification de tension ($\Delta U$) et la modification du courant ($\Delta I$) est petit, plus l'effet tampon de la batterie (2) est amélioré.

2. Procédé selon la revendication 1, **caractérisé en ce que** la valeur limite pouvant être prescrite ($G_R$) est une valeur minimale ou une valeur maximale.

3. Procédé selon la revendication 1 ou 2, **caractérisé en ce que** les modifications de courant ($\Delta I$) et/ou de tension ($\Delta U$) saisies sont traitées par plusieurs filtres parallèles avec différentes constantes de temps et **en ce que** la comparaison des signaux de sortie des filtres est utilisée comme signal de libération pour le calcul de la résistance intérieure.

4. Procédé selon l'une des revendications 1 à 3, **caractérisé en ce que** les critères de décision lors de la comparaison des signaux de sortie des filtres dépendent de l'état du réseau de bord (charge de la batterie, décharge de la batterie, état de transition) et/ou du montant de la modification du courant ou de tension.

5. Procédé selon l'une des revendications 1 à 4, **caractérisé en ce qu'**une valence est déduite à partir de l'erreur relative de la détermination de la résistance, laquelle, divisée par 100 et limitée à 1, fournit un facteur de pondération pour la résistance intérieure dynamique (Ri).

6. Procédé selon la revendication 5, **caractérisé en ce que**, lors de la valeur limite trouvée, une nouvelle valeur filtrée de la résistance intérieure dynamique (Ri) est déterminée à partir d'anciennes valeurs déjà mémorisées au préalable pour la résistance intérieure dynamique (Ri) et à partir de la valeur nouvellement déterminée pour la résistance intérieure dynamique (Ri) et pondérée selon le facteur de pondération.

7. Procédé selon la revendication 5, **caractérisé en ce que**, pour une appréciation rapide de la résistance intérieure dynamique, seules les 20 dernières valeurs calculées de la résistance intérieure dynamique sont évaluées.

8. Procédé selon la revendication 6, **caractérisé en ce que** l'affirmation sur l'effet tampon de la batterie (2) est toujours actualisée lorsqu'une nouvelle résistance intérieure dynamique (Ri) est déterminée.

9. Procédé selon l'une des revendications précédentes 1 à 8, **caractérisé en ce que**, pour la résistance intérieure dynamique (Ri), on a défini une valeur de seuil supérieure et inférieure (Tho, Thu) ainsi que deux intervalles de temps (To, Tu) pendant lesquels les seuils doivent être inférieurs (To) ou supérieurs (Tu) à la résistance intérieure dynamique (Ri) afin de sortir une affirmation sur l'effet tampon de la batterie (2).

10. Procédé selon la revendication 9, **caractérisé en ce que** les valeurs de seuil et les intervalles de temps pour différentes zones sont fixés respectivement de manière différente de sorte qu'il est possible de différencier entre un seuil et un intervalle de temps pour un état critique du réseau de bord, un seuil et un intervalle de temps pour une intervention supplémentaire, par exemple, le branchement d'une seconde batterie, et un seuil et un intervalle de temps pour un démarrage externe.

**11.** Procédé selon l'une des revendications précédentes 1 à 10, **caractérisé en ce que** des valeurs limites supplémentaires sont générées par un pilotage ciblé d'un consommateur si une suggestion n'est pas suffisante pour déterminer de manière pertinente la résistance intérieure dynamique (Ri).

**12.** Procédé selon la revendication 11, **caractérisé en ce qu'**une lunette arrière chauffante est pilotée comme consommateur.

**13.** Procédé selon l'une des revendications précédentes 1 à 12, **caractérisé par** l'étape supplémentaire « émission d'une signalisation d'avertissement (M) dès que la valeur limite ($G_R$) est dépassée ».

**14.** Ensemble pour déterminer l'effet tampon d'une batterie (2) pour la mise à disposition d'une tension (U) pour un réseau de bord (4), en particulier d'un véhicule, **caractérisé en ce qu'**on a prévu des moyens (6, 10) pour saisir et déterminer la tension et le courant ainsi qu'une unité de surveillance (8) afin de filtrer une modification de tension ($\Delta U$) et une modification du courant ($\Delta I$), saisies par les moyens (6, 10) pour saisir et déterminer la tension et le courant, et pour rechercher ensuite des valeurs relatives extrêmes, et pour déterminer la résistance intérieure dynamique de la batterie (2) selon le quotient formé par la modification de tension ($\Delta U$) et la modification du courant ($\Delta I$) avec les valeurs extrêmes relatives trouvées lors de la recherche lorsque des conditions marginales prescrites sont remplies, la surveillance de la résistance intérieure dynamique (Ri) déterminée quant au dépassement d'une valeur limite pouvant être prescrite ($G_R$) et conclusion d'une affirmation sur l'effet tampon de la batterie (2) et sortie de cette affirmation sur l'effet tampon de la batterie (2).

**15.** Ensemble selon la revendication 14, **caractérisé en ce que** le dispositif de surveillance (8) présente un dispositif pour le pilotage ciblé d'un consommateur si aucune suggestion suffisante n'existe pour déterminer la résistance intérieure dynamique (Ri).

FIG 1

FIG 2

FIG 3

FIG 4

FIG 5A

FIG 5B

FIG 6A

FIG 6B

FIG 7A

FIG 7B

FIG 8A

FIG 8B

FIG 9A

FIG 9B

FIG 9C

Zeit [s]

EP 1 377 844 B1

FIG 10A

FIG 10B

FIG 10C

EP 1 377 844 B1

FIG 11A

U-Batt [V]

FIG 11B

I-BATT [A]

FIG 11C

Ri [Ohm]

Zeit [s]

FIG 12A

U-Batt [V]

FIG 12B

I-BATT [A]

FIG 12C

Ri [Ohm]

Zeit [s]

EP 1 377 844 B1